# EUROPEAN PATENT APPLICATION

(11) **EP 0 984 455 A1**
(43) Date of publication of application: **08.03.2000**
(21) Application number: 99116514.3
(22) Date of filing: 24.08.1999
(51) Int. Cl.: G11C 7/00

(54) **Recording and reproducing apparatus**

(30) Priority: 31.08.1998 JP 24489698
(71) Applicant: MATSUSHITA ELECTRIC INDUSTRIAL CO., LTD., Kadoma-shi, Osaka 571-8501 (JP)
(72) Inventor: Tanaka, Kiichi, Osaka-shi,Osaka 536-0005 (JP); Furuta, Noriaki, Otsu-shi, Shiga 520-2101 (JP)
(74) Representative: Eisenführ, Speiser & Partner

(57) **Abstract**

A recording and reproducing apparatus (K) comprising: a nonvolatile memory (7) which acts as a recording medium for recording digital data; and a microcomputer (5) which includes at least a RAM area and performs recording and reproduction on the nonvolatile memory (7); wherein the nonvolatile memory (7) includes a first area for recording management information of whole of the nonvolatile memory (7) and a second area for recording data of respective files; wherein the first area is a file management table (FMT1) for recording the management information including at least information on start addresses of the files and information on usable space areas of the files; wherein during normal operation of recording and reproduction of the data on the second area of the nonvolatile memory (7), the management information to be recorded in the first area of the nonvolatile memory (7) is neither written in nor read out of the first area of the nonvolatile memory (7) but is written in and read out of the RAM area of the microcomputer (5); wherein when a voltage of a power source (1) of the recording and reproducing apparatus (K) has dropped below a predetermined level, the management information is written in the first area of the nonvolatile memory (7) from the RAM area of the microcomputer (5).

## Description

### BACKGROUND OF THE INVENTION

### (Field of the Invention)

The present invention relates to a recording and reproducing apparatus which includes a nonvolatile memory acting as a recording medium for recording digital data and a microcomputer for performing recording and reproduction of data on the nonvolatile memory.

### (Description of the Prior Art)

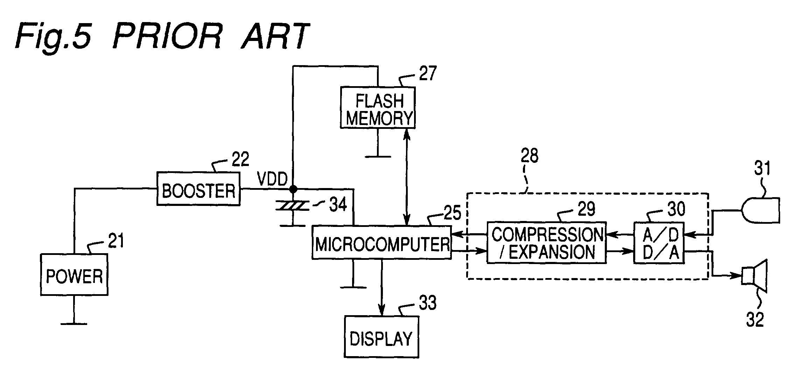

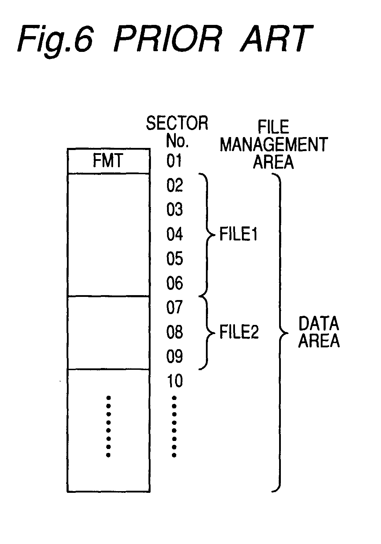

Fig. 5 shows a conventional recording and reproducing apparatus and Fig. 6 shows a data structure of a nonvolatile memory of the conventional recording and reproducing apparatus of Fig. 5. In Fig. 5, the conventional recording and reproducing apparatus includes a power source 21 formed by a battery or the like, a booster 22, a decoupling capacitor 34, a flash memory 27 acting as the nonvolatile memory, a microcomputer 25, a display 33, a sound signal processor 28, a microphone 31 and a speaker 32. The sound signal processor 28 is constituted by a compression and expansion controller 29 and an A/D and D/A converting means 30. The power source 21 supplies a fixed voltage VDD to the whole conventional recording and reproducing apparatus through the booster 22. The decoupling capacitor 34 is provided at an output of the booster 22 so as to absorb variations of the fixed voltage VDD due to load variations.

Although not specifically shown, the conventional recording and reproducing apparatus includes various operating switches such as a recording key, a playback key, an erasure key and a stop key. For example, when the recording key has been operated, sound picked up by the microphone 31 is converted into digital data by the A/D and D/A converting means 30 and then, the digital data is compressed by compression function of the compression and expansion controller 29 so as to be recorded on the flash memory 27 via the microcomputer 25. On the other hand, when the playback key has been operated, compressed digital data recorded on the flash memory 27 is read out of the flash memory 27 and then, is delivered to the compression and expansion controller 29 by way of the microcomputer 25 so as to be expanded by expansion function of the compression and expansion controller 29. Subsequently, the expanded digital data is subjected to D/A conversion by the A/D and D/A converting means 30 so as to be converted into analog data such that the analog data is reproduced by the speaker 32.

Generally, in order to perform file management efficiently, a file management table (referred to a "FMT", hereinafter) area (file management area) for collectively managing start addresses of files, etc. is provided in the flash memory 27 as shown in Fig. 6 so as to manage file information recorded in a data area of the flash memory 27.

In the conventional recording and reproducing apparatus in which the flash memory 27 is employed as the recording medium and file management is performed by ordinary management of the FMT, the following disadvantages are incurred. Namely, if the battery is instantaneously detached from the conventional recording and reproducing apparatus due to vibrations during recording, data which is being recorded is nullified. Meanwhile, if the battery is instantaneously detached from the conventional recording and reproducing apparatus during rewriting of the FMT area, the whole remaining file information may also be nullified. Furthermore, if recording and reproduction are repeated in the conventional recording and reproducing apparatus, damage at the time of erasure and recording is concentrated at the FMT area and thus, service life of the flash memory 27 is shortened extremely.

### SUMMARY OF THE INVENTION

Accordingly, an essential object of the present invention is to provide, with a view to eliminating the above mentioned drawbacks of prior art recording and reproducing apparatuses, a recording and reproducing apparatus in which recorded data is not erased even at the time of instantaneous interruption or voltage reduction of a power source and service life of a flash memory can be lengthened by eliminating frequent access to a specific portion of the flash memory.

In order to accomplish this object of the present invention, a recording and reproducing apparatus according to the present invention comprises: a nonvolatile memory which ads as a recording medium for recording digital data; and a microcomputer which includes at least a RAM area and performs recording and reproduction on the nonvolatile memory; wherein the nonvolatile memory includes a first area for recording management information of whole of the nonvolatile memory and a second area for recording data of respective files; wherein the first area is a file management table for recording the management information including at least information on start addresses of the files and information on usable space areas of the files; wherein during normal operation of recording and reproduction of the data on the second area of the nonvolatile memory, the management information to be recorded in the first area of the nonvolatile memory is neither written in nor read out of the first area of the nonvolatile memory but is written in and read out of the RAM area of the microcomputer; wherein when a voltage of a power source of the recording and reproducing apparatus has dropped below a predetermined level, the management information is written in the first area of the nonvolatile memory from the RAM area of the microcomputer.

In accordance with the present invention, even at the time instantaneous interruption or voltage reduction of the power source happens, latest management information on the data recorded in the nonvolatile memory is properly written in the nonvolatile memory and the data recorded in the nonvolatile memory is not nullified.

Furthermore, in accordance with the present invention, since frequent access to the specific portion of the nonvolatile memory is eliminated, service life of the nonvolatile memory can be lengthened.

### BRIEF DESCRIPTION OF THE DRAWINGS

This object and features of the present invention will become apparent from the following description taken in conjunction with the preferred embodiment thereof with reference to the accompanying drawings in which:
Fig. 1 is a block diagram of a recording and reproducing apparatus according to one embodiment of the present invention;
Fig. 2 is a view showing data structures of a nonvolatile memory and a microcomputer of the recording and reproducing apparatus of Fig. 1;
Figs. 3A to 3D are flowcharts showing processing sequence of the microcomputer of Fig. 2;
Fig. 4 is a flowchart showing a subroutine in the flowcharts of Figs. 3A, 3B and 3D;
Fig. 5 is a block diagram of a prior art recording and reproducing apparatus (already referred to); and
Fig. 6 is a view showing a data structure of a nonvolatile memory of the prior art recording and reproducing apparatus of Fig. 5 (already referred to).

Before the description of the present invention proceeds, it is to be noted that like parts are designated by like reference numerals throughout several views of the accompanying drawings.

### DETAILED DESCRIPTION OF THE INVENTION

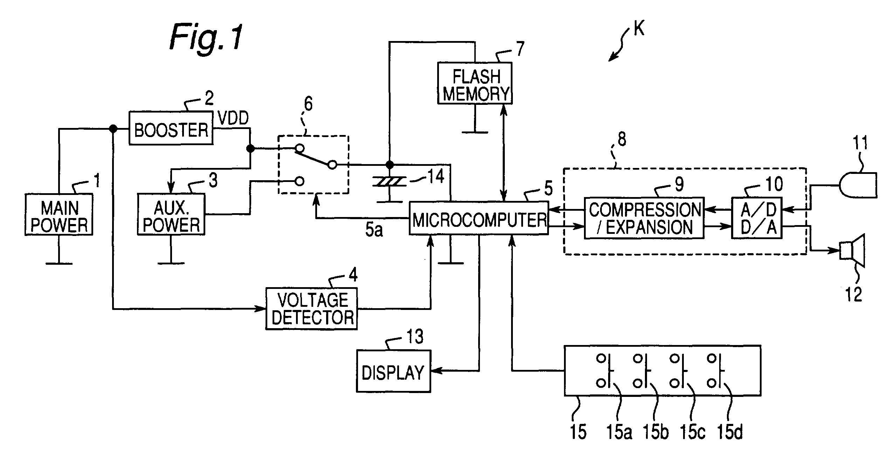

Hereinafter, one embodiment of the present invention is described with reference to Figs. 1 to 4. Fig. 1 shows a recording and reproducing apparatus K according to the one embodiment of the present invention. In the same manner as a prior art recording and reproducing apparatus of Figs. 5 and 6, the recording and reproducing apparatus K includes a main power source 1 formed by a battery or the like, a booster 2, a decoupling capacitor 14, a flash memory 7 acting as a nonvolatile memory, a microcomputer 5, a display 13, a sound signal compressor 8, a microphone 11 and a speaker 12. The sound signal processor 8 is constituted by a compression and expansion controller 9 for compressing and expanding digital data so as to efficiently record digitized data on the flash memory 7 and an A/D and D/A converting means 10 for performing A/D and D/A conversions and is provided for recording and reproducing sound through A/D and D/A conversions.

The recording and reproducing apparatus K further includes an auxiliary power source 3, a voltage detector 4, a power source switching means 6 for switching over a power source of the recording and reproducing apparatus K to one of output of the booster 2 and output of the auxiliary power source 3 and an operating panel 15 having various operating switches such as a recording key 15a, a playback key 15b, an erasure key 15c and a stop key 15d.

The main power source 1 supplies a fixed voltage VDD to the whole recording and reproducing apparatus K through the booster 2. The auxiliary power source 3 incorporates a secondary battery or the like and is recharged by output of the booster 2 so as to function as an auxiliary power source when the main power source 1 is incapable of supplying electric power to the recording and reproducing apparatus K. The auxiliary power source 3 is provided for supplying electric power to the microcomputer 5 and the flash memory 7. The voltage detector 4 is connected to the main power source 1 and monitors voltage of the main power source 1 so as to output its monitoring result to the microcomputer 5. The microcomputer 5 issues commands, for example, outputs a power source switching signal 5a to the power source switching means 6 when output of the voltage detector 4 has dropped upon detection of voltage reduction of the main power source 1.

The power source switching means 6 is controlled by the power source switching signal 5a from the microcomputer 5 and normally selects output of the booster 2. Writing, read-out and erasure on the flash memory 7 are controlled by the microcomputer 5. Input of sound to the sound signal processor 8 is performed by the microphone 11, while output of sound from the sound signal processor 8 is performed by the speaker 12. The display 13 is provided for displaying operational states of the recording and reproducing apparatus K, e.g., recording and reproducing states of the flash memory 7. The decoupling capacitor 14 is provided for output of the booster 2 so as to absorb variations of the fixed voltage VDD due to load variations.

Hereinafter, operation of the recording and reproducing apparatus K of the above described arrangement is described briefly. For example, when the recording key 15a has been operated, sound picked up by the microphone 11 is converted into digital data by the A/D and D/A converting means 10 and then, the digital data is compressed by compression function of the compression and expansion controller 9 so as to be recorded on the flash memory 7 via the microcomputer 5. Then, when the playback key 15b has been operated, the compressed digital data recorded on the flash memory 7 is read out of the flash memory 7 by the microcomputer 5 and then, is delivered to the compression and expansion controller 9 so as to be expanded by expansion function of the compression and expansion controller 9. Subsequently, the expanded digital sound data is subjected to D/A conversion by the A/D and D/A converting means 10 so as to be converted into analog data such that the analog data is reproduced by the speaker 12.

Then, operation of the recording and reproducing apparatus K at the time the battery or the like forming the main power source 1 has been instantaneously interrupted due to fall of the recording and reproducing apparatus K, etc. is described. When the main power source 1 has been instantaneously interrupted, electric power is not supplied to the booster 2 and thus, output of the booster 2 also vanishes. At the same time, the voltage detector 4 detects voltage reduction state of the main power source 1 and transmits this detection result to the microcomputer 5. Upon detection of the voltage reduction state of the main power source 1 by the voltage detector 4, the microcomputer 5 outputs the power source switching signal 5a to the power source switching means 6. In response to the power source switching signal 5a from the microcomputer 5, the power source switching means 6 changes over supply of the fixed voltage VDD of the recording and reproducing apparatus K to output of the auxiliary power source 3 from output of the booster 2 connected to the main power source 1. The auxiliary power source 3 is usually recharged by output of the booster 2 so as to be capable of outputting the fixed voltage VDD. Meanwhile, in addition to instantaneous interruption of the main power source 1 due to fall of the recording and reproducing apparatus K etc., detection of voltage reduction of the main power source 1 is likewise performed also when output of the battery or the like forming the main power source 1 has dropped below a predetermined level due to its consumption.

As is clear from the foregoing description of this embodiment, even if voltage reduction happens due to instantaneous interruption of the main power source 1 or consumption of the battery or the like forming the main power source 1, the fixed voltage VDD of the recording and reproducing apparatus K can be secured. Meanwhile, in the recording and reproducing apparatus K, the voltage detector 4 is provided as a separate circuit element but may also be replaced by an A/D converting function imparted to the microcomputer 5.

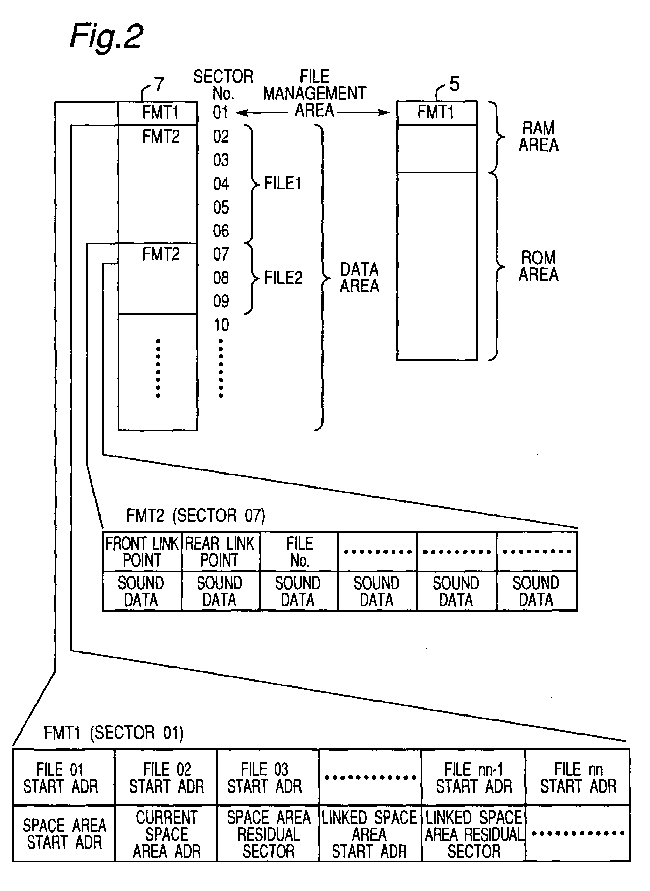

Hereinafter, file management in the flash memory 7 at the time digital data is recorded and reproduced on the flash memory 7 by the microcomputer 5 is described. An upper portion of Fig. 2 shows data structures of the microcomputer 5 and the flash memory 7 of the recording and reproducing apparatus K. The flash memory 7 is formed by an aggregate of sectors No. 01 and so on each acting as a minimum recording unit. The flash memory 7 includes a file management area acting as a first area and a data area acting as a second area. The first area is formed by the sector No. 01, while the second area is formed by the sectors No. 02 and so on. The second area is constituted by a plurality of files (record data) each having a plurality of the sectors in accordance with its data quantity.

The file management area acting as the first area is formed as a file management table (referred to as a "FMT", hereinafter) and is provided at a leading one of usable sectors of the flash memory 7, i.e., the sector No. 01. The FMT is a table for writing therein management information of the whole flash memory 7, which is composed of information including at least information on start addresses and usable space areas of each of the files as shown at a lower portion of Fig. 2. This table is designated by a first file management table (expressed by a "FMT1", hereinafter). Thus, the lower portion of Fig. 2 shows an internal structure of the first file management table FMT1 of the sector No. 01 of the flash memory 7. At the lower portion of Fig. 2, "ADR" denotes "address". Meanwhile, in the data area formed by the sectors No. 02 and so on, a second file management table (expressed by a "FMT2", hereinafter) is provided at a leading one of sectors of each of the files. A vertically middle portion of Fig. 2 shows an internal structure of the second file management table FMT2 of the sector No. 07 of the flash memory 7. As shown at the vertically middle portion of Fig. 2, the second file management table FMT2 is a table for writing therein management information composed mainly of link information on the sectors of each of the files. Thus, the file management tables FMTs formed in the flash memory 7 are classified into the first and second file management tables FMT1 and FMT2.

Meanwhile, as shown at the upper portion of Fig. 2, the microcomputer 5 has a RAM area and a ROM area. A file management table FMT1 which is expressed in the same manner as the first file management table FMT1 of the flash memory 7 for the sake of convenience is provided in the RAM area and is a table for mainly writing therein management information of the whole flash memory 7, which is composed of information including information on start addresses and usable space areas of each of the files of data recorded in the flash memory 7 in the same manner as the first file management table FMT1 formed in the file management area acting as the first area of the flash memory 7. This management information FMT1 is adapted to be written in the RAM area of the microcomputer 5 when data is recorded in the data area of the flash memory 7.

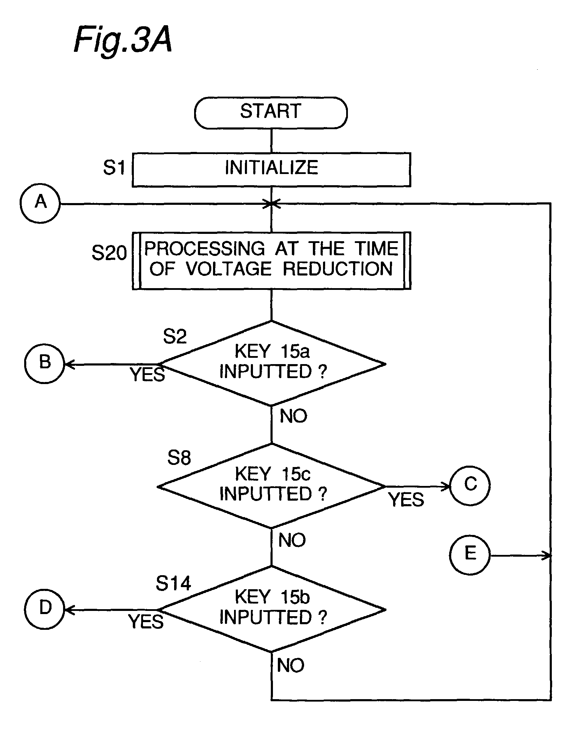

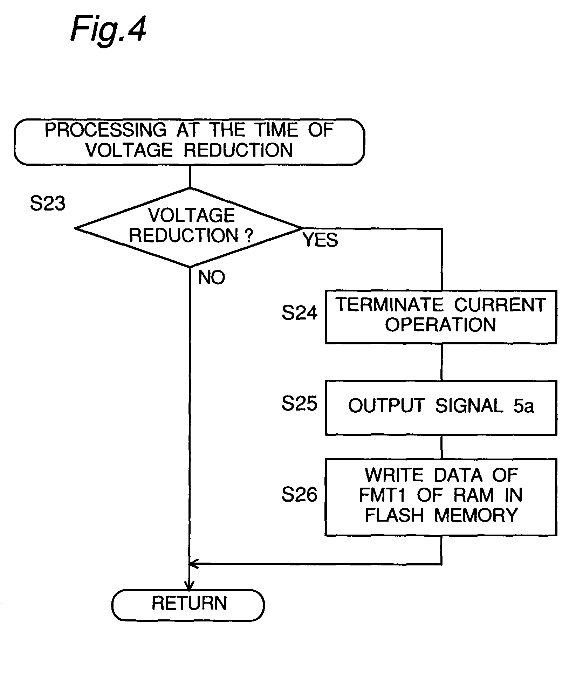

Hereinafter, operations of the recording and reproducing apparatus K at the time of recording, erasure, reproduction and detection of voltage reduction are described with reference to flowcharts of Figs. 3A to 3D and 4 illustrating processing sequence of fife management. Initially, at step S1, initialization is performed in which (1) the file management area of the first file management table FMT1 disposed at the leading sector No. 01 of the flash memory 7 is initialized, (2) for the file management table FMT1 of the RAM area of the microcomputer 5, start addresses of space areas and addresses of current space areas are set in sectors following the leading sector No. 01 of the flash memory 7, (3) linked space areas are set to be nonexistent and (4) an area corresponding to a necessary recording period, for example, a maximum recording period set in the recording and reproducing apparatus K provided with the flash memory 7 is secured.

Thereafter, a main processing for detecting key input and voltage reduction is constituted by steps S20, S2, S8 and S14 of Fig. 3A. Step S20 is a subroutine of Fig. 4 in which processings are performed when voltage reduction of the main power source 1 due to instantaneous interruption of the main power source 1 or consumption of the battery has been detected by monitoring output of the voltage detector 4 as described earlier. In the subroutine, it is initially judged at step S23 whether or not voltage reduction has occurred. In the case of "NO" at step S23, the program flow proceeds to step S2 of Fig. 3A. On the other hand, in the case of "YES" at step S23, current operation, for example, recording or reproduction is terminated at step S24. Then, at step S25, the power source switching signal 5a is outputted to the power source switching means 6 so as to change over supply of the fixed voltage VDD to output of the auxiliary power source 3 from output of the booster 2. Subsequently, at step S26, latest management information written in the file management table FMT1 of the RAM area of the microcomputer 5 is written in the first file management table FMT1 of the file management area of the flash memory 7 such that information in the file management table FMT1 of the microcomputer 5 is equalized with that of the first file management table FMT1 of the flash memory 7. Then, the program flow proceeds to step S2 of Fig. 3A.

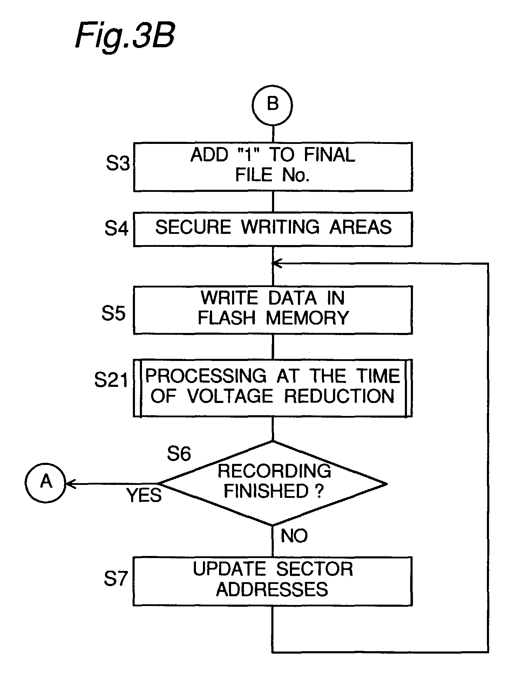

Thereafter, if it is found at step S2 that the recording key 15a has been inputted, the program flow proceeds to step S3 of Fig. 3B, in which "1" is added to the number of the final file of the file management table FMT1 of the RAM area of the microcomputer 5. Then, at step S4, writing areas are sequentially secured from a leading one of the space areas. If the space areas are not available at this time, the writing areas are secured from the linked space areas. Subsequently, at step S5, data obtained from the sound signal processor 8 and link point information are written in a corresponding sector of the flash memory 7. The next step S21 is identical with step S20 of Fig. 3A, in which processings of Fig. 4 are performed. Thus, if voltage reduction has been detected even during recording, latest management information written in the file management table FMT1 of the RAM area of the microcomputer 5 at the time is written in the first file management table FMT1 of the file management area of the flash memory 7 such that information in the file management table FMT1 of the microcomputer 5 is equalized with that of the first file management table FMT1 of the flash memory 7. Subsequently, at step S6, it is judged whether or not a request to terminate recording has been made, namely, operation of the stop key 15d, detection of a trailing end or the like has been performed. In the case of "NO" at step S6, sector addresses are updated at step S7 and then, the program flow returns to step S5 such that recording is continued. On the contrary, in the case of "YES" at step S6, recording operation is terminated and the program flow returns to step S20 of Fig. 3A.

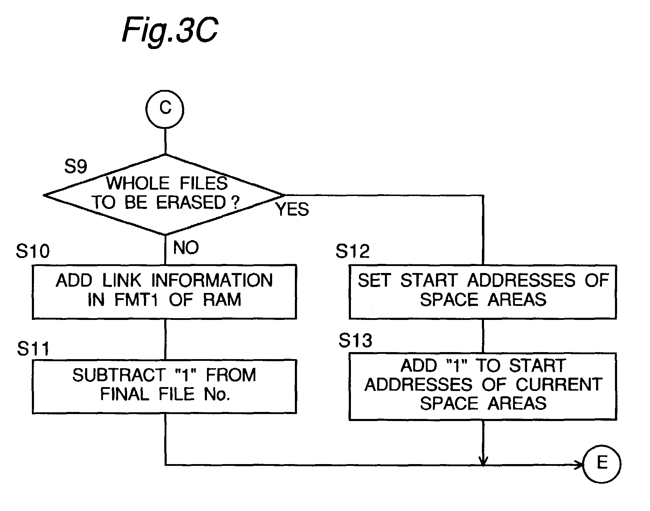

Meanwhile, in the case of "NO" at step S2, it is judged at step S8 whether or not the erasure key 15c has been inputted. In the case of "YES" at step S8, it is judged at step S9 of Fig. 3C whether or not the files should be erased wholly, namely, whether the files should be erased wholly or individually. In the case of "YES" at step S9, the program flow proceeds to step S12 in which start addresses of space areas are set in the file management table FMT1 of the RAM area of the microcomputer 5. Thereafter, "1" is added to start addresses of current space areas at step S13 and then, the program flow returns to step S20 of Fig. 3A. On the other hand, in the case of "NO" at step S9, the program flow proceeds to step S10 in which link information of the corresponding file to be erased is added to an end of linked space areas of the file management table FMT1 of the RAM area of the microcomputer 5. Subsequently, "1" is subtracted from the number of the final file of the file management table FMT1 of the RAM area of the microcomputer 5 at step S11 so as to update data of the file management table FMT1 of the RAM area of the microcomputer 5 and then, the program flow returns to step S20 of Fig. 3A.

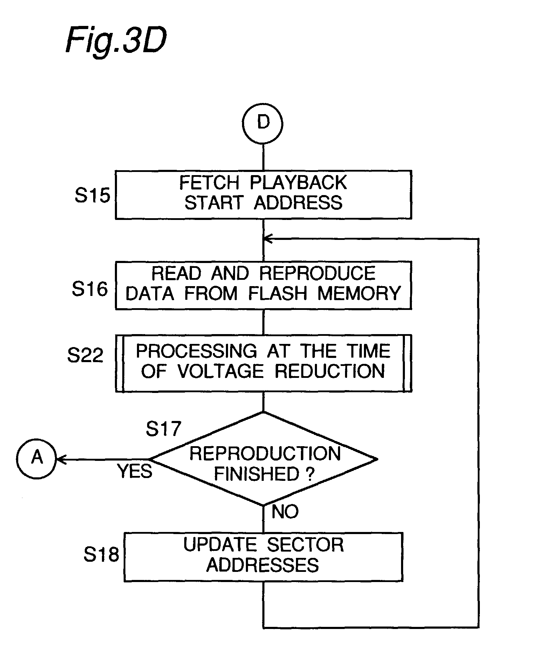

On the other hand, in the case of "NO" at step S8, it is judged at step S14 whether or not the playback key 15b has been inputted. In the case of "YES" at step S14, the program flow proceeds to step S15 of Fig. 3D, in which data on a playback start address is fetched from the corresponding file. Then, at step S16, data is read out of the flash memory 7 and one sector of the data is reproduced by the sound signal processor 8. The next step S22 is identical with step S20 of Fig. 3A, in which processings of Fig. 4 are performed. Thus, if voltage reduction has been detected even during reproduction, latest management information written in the file management table FMT1 of the RAM area of the microcomputer 5 at the time is written in the first file management table FMT1 of the file management area of the flash memory 7 such that information in the file management table FMT1 of the microcomputer 5 is equalized with that of the first file management table FMT1 of the flash memory 7. Thereafter, at step S17, it is judged whether or not a request to terminate reproduction has been made. In the case of "NO" at step S17, sector addresses are updated at step S18 and then, the program flow returns to step S16 such that reproduction is continued. On the other hand, in the case of "YES" at step S17, reproduction is terminated and the program flow returns to step S20 of Fig. 3A. Meanwhile, in the case of "NO" at step S14, the program flow returns to step S20 directly.

In the above described embodiment of the present invention, during normal operation of recording and reproduction of data on the data area of the flash memory 7, the management information is neither written in nor read out of the first file management table FMT1 of the flash memory 7 but is written in and read out of only the file management table FMT1 of the RAM area of the microcomputer 5. Meanwhile, at the time of voltage reduction of the main power source 1, contents written in the file management table FMT1 of the RAM area of the microcomputer 5 are written in the first file management table FMT1 of the flash memory 7. Therefore, since such operations in which the management information is written in and read out of the first file management table FMT1 of the flash memory 7 each time data is recorded and reproduced on the data area of the flash memory 7, i.e., frequent access to the specific portion of the flash memory 7 can be obviated, service life of the flash memory 7 can be lengthened by equalizing frequencies of use of the sectors of the flash memory 7.

As is clear from the foregoing description of the present invention, since such operations in which the management information is written in and read out of the file management table of the nonvolatile memory each time data is recorded and reproduced on the data area of the nonvolatile memory, i.e., frequent access to the specific portion of the nonvolatile memory can be obviated, service life of the nonvolatile memory can be lengthened. Meanwhile, such marked effects can be gained that latest management information on data recorded on the nonvolatile memory is properly and positively written in the file management table of the nonvolatile memory even at the time of instantaneous interruption or voltage reduction of the power source and that the data recorded on the nonvolatile memory is not nullified.

## Claims

1. A recording and reproducing apparatus (K) comprising:
a nonvolatile memory (7) which acts as a recording medium for recording digital data; and
a microcomputer (5) which includes at least a RAM area and performs recording and reproduction on the nonvolatile memory (7);
wherein the nonvolatile memory (7) includes a first area for recording management information of whole of the nonvolatile memory (7) and a second area for recording data of respective files;
wherein the first area is a file management table (FMT1) for recording the management information including at least information on start addresses of the files and information on usable space areas of the files;
wherein during normal operation of recording and reproduction of the data on the second area of the nonvolatile memory (7), the management information to be recorded in the first area of the nonvolatile memory (7) is neither written in nor read out of the first area of the nonvolatile memory (7) but is written in and read out of the RAM area of the microcomputer (5);
wherein when a voltage of a power source (1) of the recording and reproducing apparatus (K) has dropped below a predetermined level, the management information is written in the first area of the nonvolatile memory (7) from the RAM area of the microcomputer (5).

2. A recording and reproducing apparatus (K) as claimed in Claim 1, wherein the first area of the nonvolatile memory (7) is disposed at a usable leading sector of the nonvolatile memory (7).

3. A recording and reproducing apparatus (K) as claimed in Claim 1, wherein the file management table of the first area of the nonvolatile memory (7) acts as a first file management table (FMT1), while a further file management table formed by link information of each of the files of the nonvolatile memory (7) is recorded at a leading one of sectors forming each of the files of the data in the second area of the nonvolatile memory (7) and acts as a second file management table (FMT2) such that the nonvolatile memory (7) includes the first and second file management tables (FMT1, FMT2).

4. A recording and reproducing apparatus (K) comprising:
a nonvolatile memory (7) which acts as a recording medium for recording digital data;
a microcomputer (5) which includes at least a RAM area and performs recording and reproduction on the nonvolatile memory (7);
a main power source (1);
an auxiliary power source (3) which is recharged by an output of the main power source (1);
a voltage detector (4) which detects a voltage of the main power source (1) so as to output its detection result to the microcomputer (5);
a power source switching means (6) for switching over a power source of the microcomputer (5) to an output of the auxiliary power source (3) from the output of the main power source (1); and
a signal processor (8) which performs analog and digital signal transformation so as to record and reproduce the digital data on the volatile memory (7);
wherein when the voltage detector (4) has detected that the output of the main power source (1) is lower than a predetermined level, the power source switching means (6) is arranged to switch over the power source of the recording and reproducing apparatus (K) to the output of the auxiliary power source (3) from the output of the main power source (1) for use during normal operation.

5. A recording and reproducing apparatus (K) comprising:
a nonvolatile memory (7) which acts as a recording medium for recording digital data;
a microcomputer (5) which includes at least a RAM area and performs recording and reproduction on the nonvolatile memory (7);
a main power source (1);
an auxiliary power source (3) which is recharged by an output of the main power source (1);
a power source switching means (6) for switching over a power source of the microcomputer (5) to an output of the auxiliary power source (3) from the output of the main power source (1); and
a signal processor (8) which performs analog and digital signal transformation so as to record and reproduce the digital data on the volatile memory (7);
wherein the nonvolatile memory (7) includes a first area for recording management information of whole of the nonvolatile memory (7) and a second area for recording data of respective files;
wherein the first area is a file management table (FMT1) for recording the management information including at least information on start addresses of the files and information on usable space areas of the files;
wherein during normal operation of recording and reproduction of the data on the second area of the nonvolatile memory (7), the management information to be recorded in the first area of the nonvolatile memory (7) is neither written in nor read out of the first area of the nonvolatile memory (7) but is written in and read out of the RAM area of the microcomputer (5);
wherein when a voltage of the main power source (1) has dropped below a predetermined level, the power source switching means (6) changes over the power source of the recording and reproducing apparatus (K) to the output of the auxiliary power source (3) from the output of the main power source (1) in response to a command (5a) from the microcomputer (5) and the management information recorded in the RAM area of the microcomputer (5) at this time is written in the first area of the nonvolatile memory (7) from the RAM area of the microcomputer (5).

6. A recording and reproducing apparatus (K) as claimed in Claim 4, wherein the main power source (1) includes a booster (2) for boosting the output of the main power source (1).

7. A recording and reproducing apparatus (K) as claimed in Claim 5, wherein the main power source (1) includes a booster (2) for boosting the output of the main power source (1).
